# EUROPEAN PATENT APPLICATION

(11) **EP 1 607 769 A1**
(43) Date of publication of application: **21.12.2005**
(21) Application number: 04717779.5
(22) Date of filing: 05.03.2004
(51) Int. Cl.: G01T 1/20, H01L 27/14, H04N 5/32

(54) **SCINTILLATOR PANEL, SCINTILLATOR PANEL LAMINATE, RADIATION IMAGE SENSOR USING THE SAME, AND RADIATION ENERGY DISCRIMINATOR**

(30) Priority: 07.03.2003 JP 2003062291
(71) Applicant: HAMAMATSU PHOTONICS K.K., Hamamatsu-shi, Shizuoka-ken 435-8558 (JP)
(72) Inventor: SATO, Hiroto, 1-406, Hougawahaitsu, Hamamatsu-shi, Shizuoka 4300814 (JP); SUZUKI, Takaharu, c/o Hamamatsu Photonics K.K., Hamamatsu-shi, Shizuoka 4358558 (JP)
(74) Representative: Grünecker, Kinkeldey, Stockmair & Schwanhäusser Anwaltssozietät
(86) International application number: PCT/JP2004/002890
(87) International publication number: WO 2004/079397

(57) **Abstract**

The stacked scintillator panel according to the present invention is comprised of stacking a plurality of panels 1, 2, 3, 4, having scintillator 1b, 2b, 3b, and 4b deposited by vapor deposition on substrates 1a, 2a, 3a, and 4a for crystal deposition. Each of the substrates 1a, 2a, 3 a, and 4a is a light transmitting substrate that transmits at least a portion of the wavelength range of the light emitted from the corresponding scintillator 1b, 2b, 3b, or 4b upon radiation incidence.

## Description

### Technical Field

The present invention is related to a scintillator panel, a laminated scintillator panel, and a radiation image sensor and a radiation energy discriminator using the same, which are used for detecting and image taking of X-rays, γ-rays, etc., in medical and industrial applications.

### Background Art

As an example of an image sensor for X-rays, γ-rays, etc. (referred to hereinafter as "radiation"), the device described in International Patent Publication No. WO99/66345 Pamphlet (referred to hereinafter as "Document 1") is known. FIG. 9 shows such an example of a radiation image sensor. This radiation image sensor comprises a substrate 60 made of amorphous carbon (a-C) having sandblasted surface, an Al film 62 formed on one surface of the substrate 60 as a light reflecting film, and a scintillator 64 consisted of T1-doped CsI with needle-like structures formed on the surface of the Al film 62. The structure comprising the substrate 60, the A1 film 62, and the scintillator 64 is covered entirely by a polyparaxylylene film 66 to shut out vapor. Furthermore, scintillator 64 is optically coupled across the polyparaxylylene film 66 to an image pickup element 68.

When radiation enters on this radiation image sensor, the scintillator 64 emits light, and by this emitted light being detected by the image pickup element 68, the image of the incident radiation is obtained.

Also, the energy discriminator described in JP H05-75990A (referred to hereinafter as "Document 2") has a "scintillator / image pickup element" laminated structure, in which the scintillator is formed thickly. Since radiation of low energy enters a comparatively upper layer of the scintillator and causes the scintillator to emit light, the light that is generated diffuses widely before it reaches the image pickup element and is detected by the image pickup element as an image spreading across a wide range. Meanwhile, since high-energy radiation causes the scintillator to emit light upon entering a comparatively lower layer of the scintillator, the light that is generated is detected by the image pickup element as an image spreading only across a narrow range.

Thus with the energy discriminator described in Document 2, the energy of radiation is estimated by comparing the spatial spread at the image pickup element that detects the scintillator emission upon incidence of the radiation.

### Disclosure of the Invention

With the radiation image sensor described in Document 1, though a columnar scintillator is formed on a substrate, the thickness of the scintillator that can be formed is inherently limited. Thus, for example, to manufacture a radiation detector having a thick scintillator to detect high-energy radiation, there is a need to stack a plurality of scintillator panels and a plurality of substrates are required correspondingly.

With the energy discriminator described in Patent Document 2, since the incidence energy of radiation is estimated from the spatial spread on the image pickup element that detects the scintillator emission, the procedures for obtaining the incidence energy are complicated and yet the detection precision cannot be said to be high.

Therefore, it is an object of the present invention is to provide a scintillator panel that can be used in a radiation energy discriminator or image sensor of high detection precision.

In order to achieve the above object, a scintillator panel according to the present invention is characterized in consisting by stacking a plurality of panels, each comprising of a substrate for crystal deposition, made of a light transmitting material transmitting at least a predetermined wavelength light; and a scintillator deposited onto the substrate by vapor deposition method and emitting light including the wavelength range transmitted by the substrate in response to incident radiation.

By stacking panels to compose a scintillator panel, when radiation enters the scintillator panel, one can distinguish a panel where radiation has entered from other panels, thus it enables to use as an energy discriminator or an image sensor as described below. If the panels are simply stacked, however, the light emitted by the scintillator cannot be guided to the exterior and this light thus cannot be detected easily. However with the present invention, since each substrate for crystal deposition is made of a light transmitting material transmitting at least the part of light emitted from the scintillator, the light emitted from the scintillator enters the substrate for crystal deposition made of the light transmitting material, propagates inside the substrates, and can be output from the ends of the substrates. Thus when this scintillator panel is, for example, used in a radiation detector, the radiation detector can has high detection precision. Moreover, since the substrates for crystal deposition are base materials for deposition of the scintillator, these base materials can be utilized effectively for other uses.

It is preferable to interpose light shielding films between stacked panels since the light generated by the light emission from the scintillator will then be prevented from propagating to adjacent panels and avoid the occurrence of so-called crosstalk.

If each light shielding film includes a reflecting film, such as a metal film or the like, having the property of reflecting light, the light emitted from the scintillator can be fully entered in the substrates for crystal deposition and the radiation detection capability of the scintillator panel is improved.

When a retainer plate, positioned so as to face a scintillator surface that does not face a substrate after stacking, is provided, this scintillator portion can be protected from mechanical impact, soiling, etc.

The entire stacked panels is preferably coated with a protective film. When the scintillator panel is protected by a protective film, such as a polyparaxylylene film or a polyimide film, etc., the scintillator, the substrates for crystal deposition, etc., can be protected from mechanical impact, moisture, soiling, etc.

If photoelectric conversion elements are connected to the substrates for crystal deposition, when the scintillators emit light due to incident radiation, the light propagates through the interiors of the substrates for crystal deposition and is converted to electrical signals by the photoelectric conversion elements mounted at the end portions. Based on these electrical signals, an image of the incident radiation can be reproduced. A CCD or other image pickup element may be used in place of the photoelectric conversion elements.

Also, when photodetectors such as solid-state linear sensors or the like are connected in place of the photoelectric conversion elements, the energy of the incident radiation can be discriminated.

Or, a scintillator panel according to the present invention may comprise a substrate having a front surface and a corresponding back surface, and scintillator deposited on the front surface and back surface of the substrate respectively.

There is a thickness limit for a scintillator formed on a surface of a scintillator panel. However, with this scintillator panel, by forming scintillator at both surfaces, the scintillator thickness of the scintillator panel as a whole can be made approximately twice that of a scintillator panel with which a scintillator is formed on just one surface (front surface). Thus in manufacturing a radiation detector that uses such scintillator panels, the number of scintillator panels required can be made few.

Here, by setting the substrate made of a light transmitting material having a transmitting property with respect to the light emitted from the scintillator, the light emitted from the scintillator can be guided definitely through the substrate to a desired position.

Here, by using glass as the substrate, the light emitted from the scintillator can be guided definitely and the scintillator can be supported favorably.

Also, by setting the substrate made of a metal material, a scintillator member of high strength can be obtained. Also by setting the substrate made of a metal material, the light emitted from the scintillator can propagate and be guided by reflection between substrate surfaces.

By setting the substrate made of a carbon-based material, the obstruction of X-rays and other radiation incident can be prevented.

Furthermore, by forming a protective film on the surfaces of the scintillator, the scintillator can be protected from physical and chemical damage due to external causes.

Scintillator has generally high deliquescence properties and degrade easily when water becomes attached. By the protective film having a moisture-proof property, contact of the scintillators with water can be prevented favorably. Deliquescence of the scintillator can thus be prevented favorably.

Also by forming a reflecting film on the surfaces of the scintillator, the light emitted from the scintillator generated by the scintillation emission due to radiation incident can be prevented from leaking outside the scintillator member and the light amount of the detected light can be made large.

Meanwhile, the stacked scintillator panel of the present invention is formed by stacking a plurality of any of the above-described scintillator panels. For the same scintillator thickness, the number of scintillator panels in the interior can be reduced and the thickness of the laminate as a whole can also be reduced.

By connecting photoelectric conversion elements, an image pickup element, or photodetectors to this stack, a radiation image sensor or a radiation energy discriminator is obtained.

### Brief Description of the Drawings

FIG. 1 is a sectional view of an energy discriminator as a first embodiment of the present invention.
FIG. 2 is a sectional view of an image sensor as a second embodiment of the present invention.
FIG 3 is a sectional view of an image sensor as a third embodiment of the present invention.
FIG. 4 is a sectional side view of an image sensor as a fourth embodiment of the present invention.
FIG 5 is an enlarged sectional side view of a scintillator panel used in the energy discriminator of FIG. 4.
FIGS. 6A to 6D are process diagrams illustrating the manufacturing processes of the scintillator panel shown in FIG. 5.
FIG. 7 is a sectional side view of an image sensor as a fifth embodiment of the present invention.
FIG 8 is a sectional side view of an energy discriminator as a sixth embodiment of the present invention.
FIG. 9 is a sectional view of a conventional radiation position detector.

### Best Modes for Carrying Out the Invention

Preferred embodiments of the present invention shall now be described in detail with reference to the attached drawings. To facilitate the comprehension of the explanation, the same reference numerals denote the same parts, where possible, throughout the drawings, and a repeated explanation will be omitted. Also, each drawing may have a portion which is exaggerated in scale or omitted for explanation and the dimensional proportions in the drawings do not match the actual dimensional proportions.

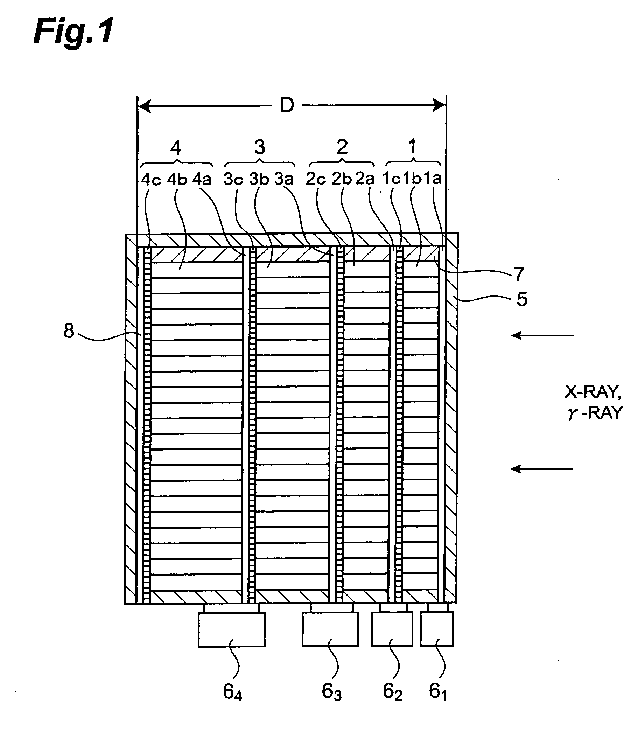

FIG. 1 shows a first embodiment of the present invention, which is a radiation energy discriminator using a scintillator panel.

In FIG. 1, the energy discriminator comprises four panels 1, 2, 3, and 4 (having scintillator 1b, 2b, 3b, and 4b, respectively), which receive radiation, a protective film 5, which covers entire panels 1, 2, 3, and 4, respectively, to prevent absorbing moisture by the scintillator 1b, 2b, 3b, and 4b, solid linear sensors or other photodetectors 61, 62, 63, and 64, which are respectively connected to end portions at one side of substrates 1a, 2a, 3a, and 4a for crystal deposition in the panels 1, 2, 3, and 4 and respectively detect the light emitted from the scintillator 1b, 2b, 3b, and 4b upon incidence of radiation, and supporting films 7, which are disposed at the end portions at the other side of the substrates 1a, 2a, 3a, and 4a for crystal deposition to support side face portions of the scintillator 1b, 2b, 3b, and 4b.

The panels 1, 2, 3, and 4 have a common structure except for the thickness of the scintillator 1b, 2b, 3b, and 4b, that is a structure wherein the substrates 1a, 2a, 3a, 4a for crystal deposition, the scintillator 1b, 2b, 3b, and 4b, and reflecting films 1c, 2c, 3c, and 4c are laminated in that order from the side of radiation incidence.

Here, the reflecting films 1c, 2c, 3c, and 4c have a function of serving as light shielding films that prevent light emitted from the respective scintillator 1b, 2b, 3b, and 4b from propagating to adjacent panels and are members for reflecting and efficiently guiding the emitted light generated in the respective scintillator 1b, 2b, 3b, and 4b to the substrates 1a, 2a, 3a, and 4a for crystal deposition. Here, the width D, which is the sum of the thicknesses of the panels 1, 2, 3, and 4, determines the maximum incidence radiation energy that the energy discriminator can detect, and the wider the width D, the higher the incidence energy of X-rays, γ-rays, etc. that can be detected.

The thickness of each scintillator 1b, 2b, 3b, and 4b is related to the detection resolution of the detected incidence radiation energy, and if we make the thin scintillator, the incidence energy width that can be detected by each individual scintillator becomes narrower, while if we make the thick scintillator, the incidence energy width that can be detected by each individual scintillator becomes wider. Thus by adjusting the thickness of the scintillator as desired, the energy resolution of the energy discriminator can be adjusted. For example, in the present embodiment, the width of the scintillator 1b disposed at the radiation incident side (right side in Fig. 1) is made narrow and the widths of the scintillator 2b, 3b, and 4b are widened gradually with the distance from the incidence side. Thus the energy resolution can be made high and energy widths can be discriminated finely for radiation of a low energy region. Also, the energy resolution is made low and energy widths are discriminated roughly for radiation of a high energy region.

Furthermore, though in the present embodiment, the panels 1, 2, 3, and 4 are stacked in four layers, the number of stacked panels is not limited thereto and may be changed as desired. Also, in order to protect the scintillator 4b at the uppermost layer of panel 4 from mechanical impact and soiling, a retainer plate 8, formed of the same material as the substrates for crystal deposition, is adhered separately at the outer side of reflecting film 4.

The panels 1, 2, 3, and 4 respectively have the scintillator 1b, 2b, 3b, and 4b, which are respectively formed of needle-like crystals of Tl doped CsI or the like, deposited by vapor deposition or other chemical vapor deposition method on the substrates 1a, 2a, 3a, and 4a for crystal deposition that are respectively formed of light transmitting material that transmits light (which is visible light in the present embodiment but may be ultraviolet light or infrared light depending on the type of the scintillator) emitted by the scintillator 1b, 2b, 3b, and 4b, respectively, and metal thin films of Al, Ag, Cr, Cu, Ni, Ti, Mg, Rh, etc., or resin films of Teflon, etc., are layered as the reflecting films 1c, 2c, 3c, and 4c by CVD method, etc., on the surfaces of scintillator 1b, 2b, 3b, and 4b, respectively. The reflecting films may also be formed so as to cover the side face portions at the four sides of the scintillator 1b, 2b, 3b, and 4b. By doing so, the light generated in the vicinity of the four side face portions of scintillator 1b, 2b, 3b, and 4b can be introduced efficiently into the substrates 1a, 2a, 3a, and 4a for crystal deposition.

In this energy discriminator, CsI, which is the material of the scintillator 1b, 2b, 3b, and 4b, has high hygroscopicity, and in order to prevent deliquescence, the each entire panel 1, 2, 3, and 4 is coated with a protective film 5, made of polyparaxylylene. Besides polyparaxylylene, polymonochloroparaxylylene, polydichloroparaxylylene, polytetrachloroparaxylylene, polyfluoroparaxylylene, polydimethyl-paraxylylene, polydiethylparaxylylene, etc., may be used as the protective film 5.

As each of the supporting films 7 for protecting the side face portions of the scintillator 1b, 2b, 3b, and 4b, a polyimide film, which is good in compatibility with CsI, is favorable. The retainer plate 8, which is provided to protect the scintillator 4b of the panel 4 from mechanical impact, contamination, etc., may be formed using the same material (glass, quartz, etc.) as the other substrates 1a, 2a, 3a, and 4a for crystal deposition.

The actions (operations) of this energy discriminator shall now be described.

Radiation enters on the energy discriminator along the direction of stacking panel 1 to panel 4 (from the right to left in FIG. 1). The incident radiation differs in penetration depth in accordance with the magnitude of its incidence energy and the higher the incidence energy, the deeper the penetration.

The incident radiation into the energy discriminator thus arrives, in accordance with its incidence energy, at a penetration depth corresponding to any of the panels 1, 2, 3, and 4 and at the point of arrival, causes the corresponding scintillator 1b, 2b, 3b, or 4b to emit light. More specifically, if the radiation reaches the panel 2, the scintillator 2b emits light, and if the radiation reaches the panel 4, the scintillator 4b emits light.

A portion of the light emitted at scintillator 1b, 2b, 3b, or 4b are reflected by the corresponding reflecting film 1c, 2c, 3c, or 4c and enters in the corresponding substrate 1a, 2a, 3a, or 4a for crystal deposition, and the remaining portion enters directly in the corresponding substrate 1a, 2a, 3a, or 4a for crystal deposition. The incident light in the substrate 1a, 2a, 3a, or 4a for crystal deposition propagates through the interior of the substrate 1a, 2a, 3a, or 4a for crystal deposition, reaches the corresponding light detector 61, 62, 63, or 64, and that the radiation reached scintillator 1b, 2b, 3b, or 4b is thus detected by the corresponding light detector 61, 62, 63, and 64.

With the energy discriminator of this embodiment, the light emitted from the scintillator 1b, 2b, 3b, and 4b thus propagates through the respective substrates 1a, 2a, 3a, and 4a for crystal deposition. Thus with the energy discriminator of this embodiment, since energy discrimination of radiation can be performed directly instead of performing the indirect detection of evaluating the spatial spread on an image pickup element that detects the emission of the scintillator, the detection precision can be made high.

Also, by changing the thickness of each individual panels 1, 2, 3, and 4 consisting the energy discriminator, the radiation energy resolution can be adjusted. Also by changing the entire thickness of the scintillator panel, the maximum energy of radiation that can be measured by the energy discriminator can be changed.

A manufacturing method of this energy discriminator shall now be described.

First, the respective panels 1, 2, 3, and 4 are manufactured. That is, needle-like crystals (columnar crystals) of Tl doped CsI, which becomes the scintillators 1b, 2b, 3b, and 4b are grown by vacuum vapor deposition to desired thicknesses (several dozen to several hundred µm) on the substrates 1a, 2a, 3a, and 4a for crystal deposition, made of glass, quartz, or other light transmitting material.

Here, the material of the substrates 1a, 2a, 3a, and 4a for crystal deposition is not restricted in particular as long as it is a material having a light transmitting property. For example, glass or quartz, etc., is favorable, and for example, slide glass (thickness: approximately 170µm) for microscopic observation, etc., may be used.

Reflecting films 1c, 2c, 3c, and 4c, made of Al, etc., are then formed by CVD method, etc., on the surfaces of the each scintillator 1b, 2b, 3b, and 4b to thereby obtain the respective panels 1, 2, 3, and 4.

The four panels 1, 2, 3, and 4 are then stacked and adhered together in that order, and in order to protect the scintillator 4b of the panel 4 of the uppermost layer, the retainer plate 8 is adhered onto the reflecting film 4c. The retainer plate 8 is not limited to that of the same type of material as the substrates for crystal deposition and may be any material that can protect the reflecting film 4c and scintillator 4b at the inner side from mechanical impact and soiling.

Polyimide is then coated on the side face portions of the four stacked panels 1, 2, 3, and 4 and cured to form the supporting films 7. Furthermore, the entire four panels 1, 2, 3, and 4 is coated with a polyparaxylylene film, which is the protective film 5, and lastly, the photodetectors 61, 62, 63, and 64 are connected to the respective end portions of the substrates 1a, 2a, 3a, and 4a for crystal deposition to thereby provide the energy discriminator.

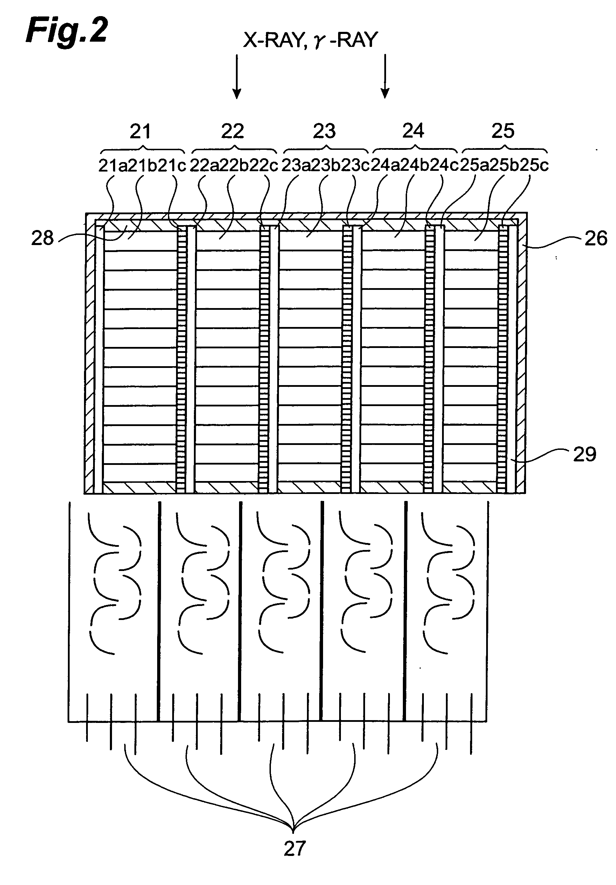

FIG. 2 shows a second embodiment of the present invention and is a sectional view of a radiation image sensor that uses scintillator panel of the present invention. The image sensor comprises five panels 21, 22, 23, 24, and 25 (respectively having scintillator 21b, 22b, 23b, 24b, and 25b which convert radiation to visible light) onto which radiation enters, a protective film 26, which covers the entire panels 21, 22, 23, 24, and 25 to prevent moisture absorption by the scintillator 21b, 22b, 23b, 24b, and 25b, photoelectric converters 27, comprising of photomultiplier tubes connected to end portions at one side of the substrates 21a, 22a, 23a, 24a, and 25a for crystal deposition inside the panels 21, 22, 23, 24, and 25 and obtain electrical signals by detecting the respective emitted light generated in the scintillator 21b, 22b, 23b, 24b, and 25b upon radiation incidence, and supporting films 28, disposed at the end portions at the other side of the substrates 21 a, 22a, 23a, 24a, and 25a for crystal deposition to protect side face portions of the scintillator 21b, 22b, 23b, 24b, and 25b.

Though only five photoelectric converters 27 are illustrated in FIG. 2, photoelectric converters are positioned in five columns along the depth direction of the figure as well. That is, 5 × 5 or 25 photoelectric converters are positioned.

These photoelectric converters 27 are connected to an image monitor via a circuit board having an image processing circuit not shown in the figure. The electric signals output from the photoelectric converters 27 are converted to image signals by the image processing circuit of the circuit board and output to the monitor not shown in the figure. An image in accordance with the output image signals is displayed on this monitor.

Also, since radiation is input into the image sensor according to the present embodiment from the upper side and along a direction intersecting the direction of the stacking panel 21 to 25, that is for example, the direction orthogonal to the direction of stacking panel 21 to 25, the input radiation proceeds along the direction orthogonal to the direction of stacking panel 21 to 25. Thus by adjusting the sizes of the panels 21, 22, 23, 24, and 25, an image sensor in accordance with the magnitude of the energy of the radiation used can be arranged.

The panels 21, 22, 23, 24, and 25 have common structures wherein the substrates 21a, 22a, 23a, 24a, and 25a for crystal deposition made of light transmitting material, the scintillator 21b, 22b, 23b, 24b, and 25b, and the reflecting films 21c, 22c, 23c, 24c, and 25c are stacked in that order. Also, in order to protect the scintillator 25b and the reflecting film 25c of the panel 25 from mechanical impact and soiling, a retainer plate 29 is adhered separately to the outer side of the reflecting film 25c.

The material used as the substrates 21a, 22a, 23a, 24a, and 25a for crystal deposition, the material used as the scintillator 21 b, 22b, 23b, 24b, and 25b, the material used as the reflecting films 21c, 22c, 23c, 24c, and 25c, the material used as the protective film 26, and the material used as the supporting films 28 are the same as those of the first embodiment and thus description thereof shall be omitted. Also, though with the present embodiment, the five panels 21, 22, 23, 24, and 25 are stacked, the number of panels stacked is not restricted thereto and may be increased or decreased in accordance with the size of the image.

The actions (operations) of this image sensor shall now be described.

In this embodiment, radiation enters from above the image sensor along the direction (vertical direction in FIG. 2) orthogonal to the direction of stacking panel 21 to 25. The incident radiation in the image sensor arrives at the panels 21, 22, 23, 24, and 25 and causes the scintillator 21b, 22b, 23b, 24b, and 25b to emit light at the point of arrival. When the scintillator 21b, 22b, 23b, 24b, and 25b emit light, the light enters in any of the substrates 21a, 22a, 23a, 24a, and 25a for crystal deposition, made of light transmitting material, and is transmitted via the substrates 21a, 22a, 23a, 24a, and 25a for crystal deposition to the respective photoelectric converters 27, which are photomultiplier tubes. The light emitted from the scintillator 21b, 22b, 23b, 24b, and 25b is then converted to electric signals at the photoelectric converters 27.

Based on the electric signals output from the respective photoelectric converters 27, image processing is carried out by the image processing circuit of the circuit board to form image signals. By outputting these image signals to the monitor, an image is displayed on the monitor.

Thus with the image sensor of the second embodiment, the incident position of incident radiation on the scintillator 21b, 22b, 23b, 24b, and 25b can be made known and imaging of the radiation can be performed by a simple structure of stacking the panels 21, 22, 23, 24, and 25.

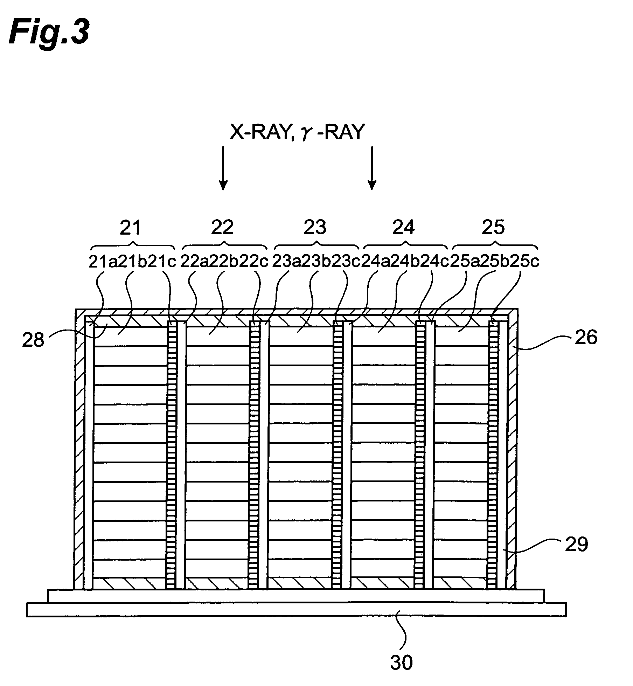

Also, in the case where the scintillator panel according to the present invention is used in an image sensor, a CCD or other image pickup element may be used without the use of photoelectric converters that comprise photomultiplier tubes, etc. To describe an example using an image pickup element with reference to a third embodiment, illustrated in FIG. 3, the same scintillator panel as that shown in FIG. 2 is used, and a CCD 30 is mounted to end portions at one side of the respective substrates 21b to 25b for crystal deposition of the panels 21 to 25 of this scintillator panel. With this embodiment, an image is formed not upon conversion of light to electrons by photomultiplier tubes or other photoelectric converters but the light that arrives upon propagating through the substrates 21 b to 25b for crystal deposition can be picked up as they are by the CCD camera.

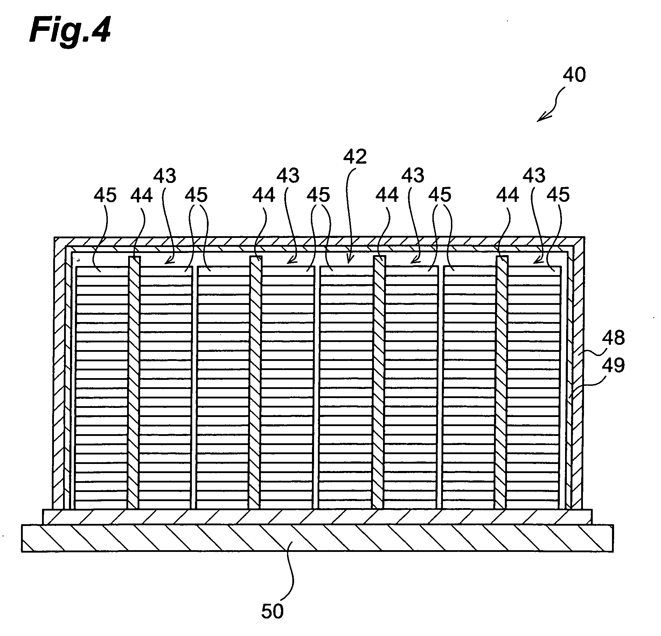

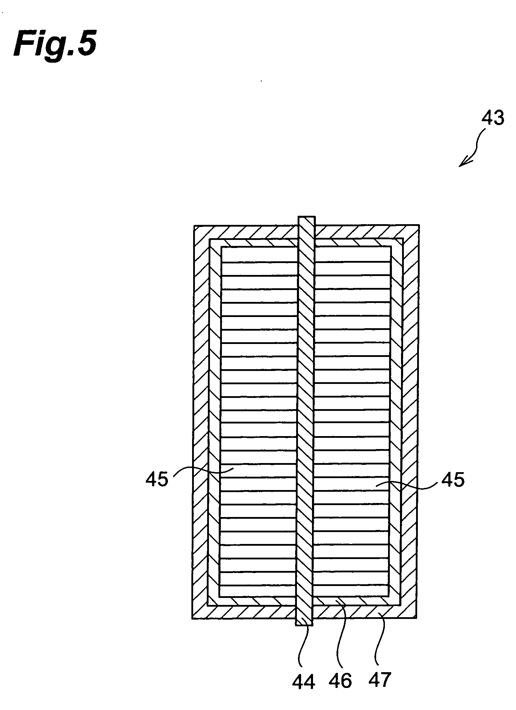

As a fourth embodiment of the present invention, a radiation image sensor shall now be described. FIG. 4 is a sectional side view of this image sensor, and FIG. 5 is an enlarged sectional side view of a scintillator panel used in this image sensor.

As shown in FIG. 4, a image sensor 40 of the present embodiment is provided with a stacked scintillator panel 42. The stacked scintillator panel 42 is formed by stacking a plurality of, that is, in the present embodiment, four scintillator panels 43. These scintillator panels 43 are positioned so that adjacent scintillator panels are in substantially close contact with each other.

As shown in FIG. 5, each scintillator panel 43 is provided with a rectangular substrate 44. The substrate 44 is made of glass, has a radiation transmitting property, and enables propagation of light (visible light) through its interior. Besides glass, the substrate 44 may be made of amorphous carbon or other material having carbon as the main component.

Scintillator 45, which converts X-rays, γ-rays, and other radiation to visible light by scintillation emission, are formed by vapor deposition on the front surface and back surface (the respective side surfaces in FIG 4) of the substrate 44. Tl-doped CsI is used for example as the scintillator 45, and CsI has a structure wherein a plurality of needle-like crystals (columnar crystals) are bristled together.

Furthermore, a protective film 46 is formed on the surfaces of the substrate and the scintillator 45, formed on the front and back surfaces of the substrate, and the surfaces of the scintillator 45 are covered by the protective film 46. The protective film 46 is, for example, made of polyparaxylylene and prevents physical and chemical damage of the scintillator 45. In particular, by using polyparaxylylene, a high moisture-proof property is exhibited. Though the scintillator 45 has highly hygroscopicity, the deliquescence of the scintillator 45 is prevented by the protection by the high moisture-proof property of polyparaxylylene. Besides the above-mentioned polyparaxylylene, a xylene-based resin, such as polyparachloroxylylene, may be used as the protective film 46.

A metal reflecting film 47, which serves as a reflecting film, is furthermore formed on the surface of the protective film 46 that covers the scintillator 45. The metal reflecting film 47 is, for example, made of aluminum or other metal and covers the surfaces of the scintillator 45 across the protective film 46 and prevents the light emitted from the scintillator 45 from leaking to the outer side of the scintillator 45. Besides the above-mentioned aluminum (Al), metals of various types can be cited as the metal to be used as the metal reflecting film 47 and, for example, a material containing a substance among the group consisting of Ag, Cr, Cu, Ni, Ti, Mg, Rh, Pt, and Au may be used. With the scintillator panel 43 shown in FIG. 4, only the substrate 44 and scintillator 45 are shown, and illustration of the protective film 46 and metal reflecting film 47 is omitted.

The stacked scintillator panel 42 formed of a plurality of the scintillator panels 43, is housed inside a case 48, with an open lower face, as shown in FIG. 4. Though the case 48 is, for example, made of a resin having a radiation transmitting property, it may be formed instead of a glass tube or amorphous carbon or other material having carbon as the main component. A metal reflecting film 49, formed of aluminum is formed on the inner side of the case 48.

The stacked scintillator panel 42 is fixed at the inner side of the case 48 by a fixing member, for example, made of a transparent resin and is positioned so as to fill up as much as possible the inner side of the case 48. The fixing member is, for example, made of solidifying molten resin and can be formed by pouring resin in the molten state into the case 48 and then cooling as it is.

Furthermore, on the open face of the case 48, a solid-state image pickup element 50 which serves as the image pickup element is disposed. The solid-state image pickup element 50 which serves as the image pickup element is connected to end portions of the substrates 44 in the scintillator panels 43, and the solid-state image pickup element 50 receives the light transmitted via the substrates 44. The solid-state image pickup element 50 is connected to an monitor not shown in the figure, and the image picked up by the solid-state image pickup element 50 can be displayed on the monitor.

The actions of the image sensor according to the present embodiment with the above-described arrangement shall now be described.

With the image sensor 40 according to the present embodiment, radiation enters from an incident surface at a position opposite the open face of the case 48. The incident radiation from the incidence surface proceeds in straight lines as it is, is transmitted through the metal reflecting films 47 and the protective films 46 of the scintillator panels 43, and arrives at the scintillator 45. By collision of the radiation with the scintillator 45, the scintillator 45 causes scintillation emission, thereby generating visible light. The visible light generated by the scintillator 45 is emitted directly to the substrate 44 or to a metal reflecting film 47. Here, the visible light emitted directly to the substrate 44 enters the substrate 44 as it is, propagates inside the substrate 44, and arrives at the solid-state image pickup element 50. The visible light emitted to the metal reflecting film 47 is reflected by the metal reflecting film 47, and eventually enters the substrate 44. The visible light that thus enters the substrate 44 propagates through the substrate 44 and arrives at the solid-state image pickup element 50.

The incident radiation thus from the upper face of the case 48 thus proceeds in straight lines as it is, is converted to visible light by the scintillator 45 in the scintillator panels 43, and is transmitted via the substrates 44 to the solid-state image pickup element 50. Since a radiation image that enters from the incidence surface is thus made visible and taken by the solid-state image pickup element 50, the functions of an image sensor are exhibited.

With image sensor 40 according to the present embodiment, the stacked scintillator panel 42 is formed by stacking a plurality of the scintillator panels 43. The scintillator 45 is formed on the front and back surfaces of each scintillator panels 43 that make up the stacked scintillator panel 42. Since there is a limit to the thickness of a scintillator formed on a substrate, if a scintillator is formed on just the surface at one side, for example, on just the front surface, a large number of substrates will be required to manufacture the image sensor. Meanwhile, with the scintillator panel 43 according to the present embodiment, since the scintillator 45 is formed on both the front and back surfaces, a thickness of approximately twice that of a scintillator panel on which the scintillator is formed on just the surface at one side can be secured. Thus in comparison to a case where an image sensor is manufactured by housing a scintillator panel, with which the scintillator is formed on just the surface at one side, the number of scintillator panels required can be made approximately half by simple calculation. Since one substrate is used in one scintillator panel, by simple calculation, the number of substrates used can be halved. The number of substrates required to provide an image sensor can thus be reduced. As a result, the thickness of scintillator panels that are required to provide the same scintillator thickness can be reduced and the entire device can be made more compact.

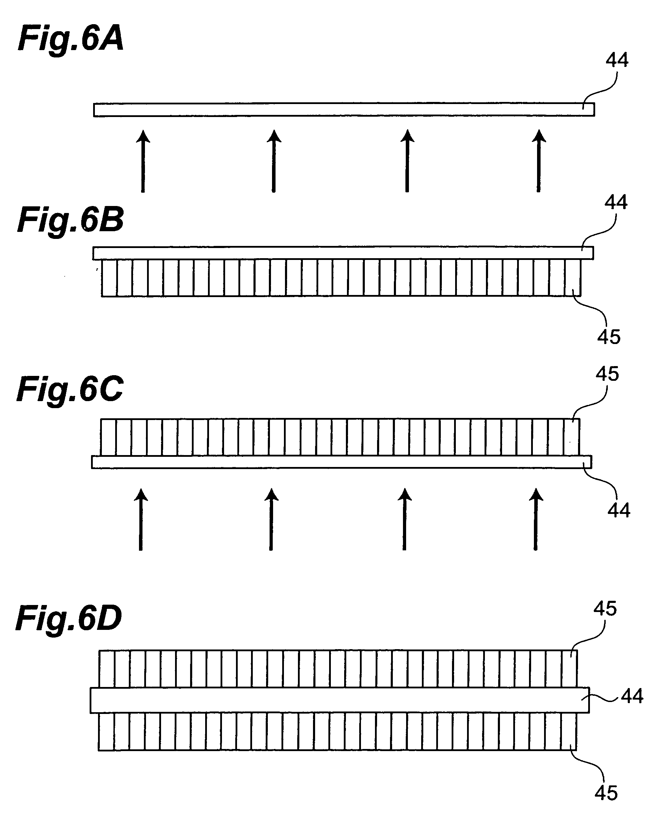

Each scintillator panel 43 used in the image sensor 40 can be manufactured as follows. To describe the manufacturing process using FIGS. 6A to 6D, first, as shown in FIG. 6A, substrate 44 is prepared. For this substrate 44, CsI:Tl, which is a scintillator component, is evaporated from below using an evaporator not shown in the figure and is vapor-deposited onto one surface of the substrate 44. When vapor-deposition is made to proceed as it is, the scintillator 45 undergoes vapor deposition as shown in FIG. 6B and the scintillator 45 grows to the desired thickness, for example, to approximately 0.5mm and needle-like structures are formed. The vapor-deposition of the scintillator component is then stopped once and the top and bottom sides of the substrate 44 are inverted, and the surface of the substrate 44 at which the scintillator is not formed is faced downwards as shown in FIG. 6C. The evaporation of the scintillator component is then restarted in this state to vapor-deposit the scintillator and perform vapor deposition of the scintillator 45 on the lower surface (the surface on which the scintillator is not formed) of the substrate 44. The scintillator 45 thus grows and needle-like structures are formed as shown in FIG. 6D. An annealing step is thereafter performed. Each of the substrate 44 and the scintillator 45 are then coated by the protective film 46, formed of polyparaxylylene, and then the metal reflecting film 47 is formed. The scintillator panel 43 is thus manufactured.

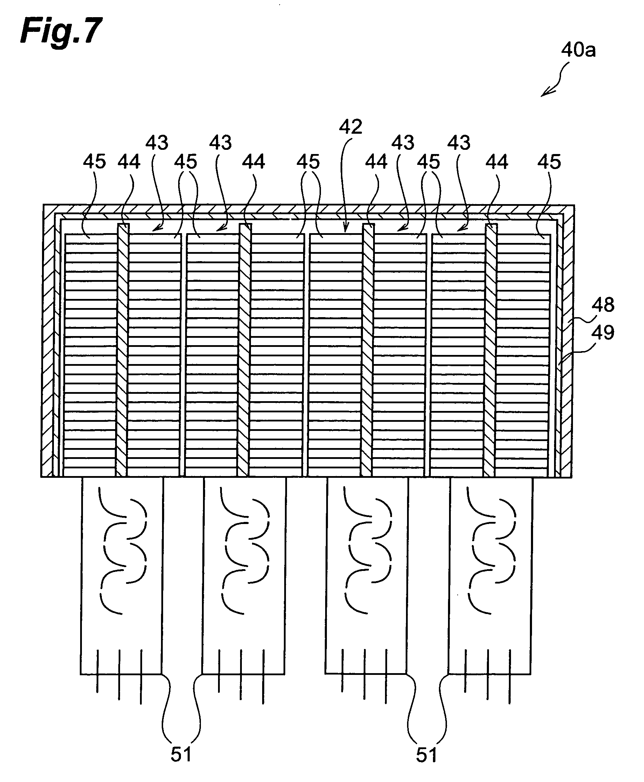

Though the solid-state image pickup element 50 is used here for picking up a visible light image, the present invention is not limited thereto. FIG. 7 is a sectional side view of an image sensor of a fifth embodiment. As shown in FIG. 7, this image sensor 40a comprises the stacked scintillator panel 42 of the same arrangement as that of the above-described fourth embodiment and the case 48 that houses the stacks. Also as with the above-described fourth embodiment, the metal reflecting film 49 is formed on the interior of the case 48.

Meanwhile, at the sides of the open face of the case 48 of the respective substrates 44 of the scintillator panels 43 that form the stacked scintillator panel 42 of the present embodiment are mounted a plurality of photoelectric converters, such as photomultiplier tubes 51. Though only four photomultiplier tubes 51 are shown in FIG. 7, a plurality of the photomultiplier tubes 51 are also aligned in the depth direction of the paper surface and are positioned in four such columns. Thus in total, 4 × 4 = 16 photomultiplier tubes are positioned. These photomultiplier tubes 51 are connected to an image monitor via an circuit substrate, not shown in the figure, having an image processing circuit. The electric signals output from the photomultiplier tubes 51 are converted to image signals by the image processing circuit of the circuit board and output to the monitor. An image that is in accordance with the output image signals is displayed on this monitor.

Also, since radiation is input into the image sensor according to the present embodiment from the upper side and along a direction intersecting the direction of stacking the stacked scintillator panel 42, that is for example, the direction orthogonal to the direction of stacking the stacked scintillator panel 42, the input radiation proceeds in the direction orthogonal to the direction of stacking the stacked scintillator panel 42. Thus by adjusting the size of substrate 44 of each scintillator panel 43, an image sensor that is in accordance with the magnitude of the energy of the radiation used can be arranged.

With the image sensor 40a according to the present embodiment having the above arrangement, the incident radiation from above the image sensor 40a along the direction (vertical direction in FIG. 7) orthogonal to the direction of stacking the stacked scintillator panel 42. The incident radiation on the image sensor 40a arrives at the scintillator 45 and causes the scintillator 45 to emit light at the point of arrival. When the scintillator 45 emits light, the light enters on any of the substrates 44, formed of light transmitting material, and is transmitted via the substrates 44 to the photomultiplier tubes 51. The light emitted from the scintillator 45 is then converted to electric signals at the photomultiplier tubes 51. Then based on the electric signals output from the respective photomultiplier tubes 51, image processing is carried out by the image processing circuit of the circuit board to form image signals. By outputting these image signals to the monitor, an image is displayed on the monitor.

Thus with the image sensor 40a according to the present embodiment, since the same scintillator panel laminate 42 as that of the above-described fourth embodiment is used, the number of substrates required to provide an image sensor can be made few. Also, since photomultiplier tubes are used as image pickup elements, the image that is picked up can be made clear.

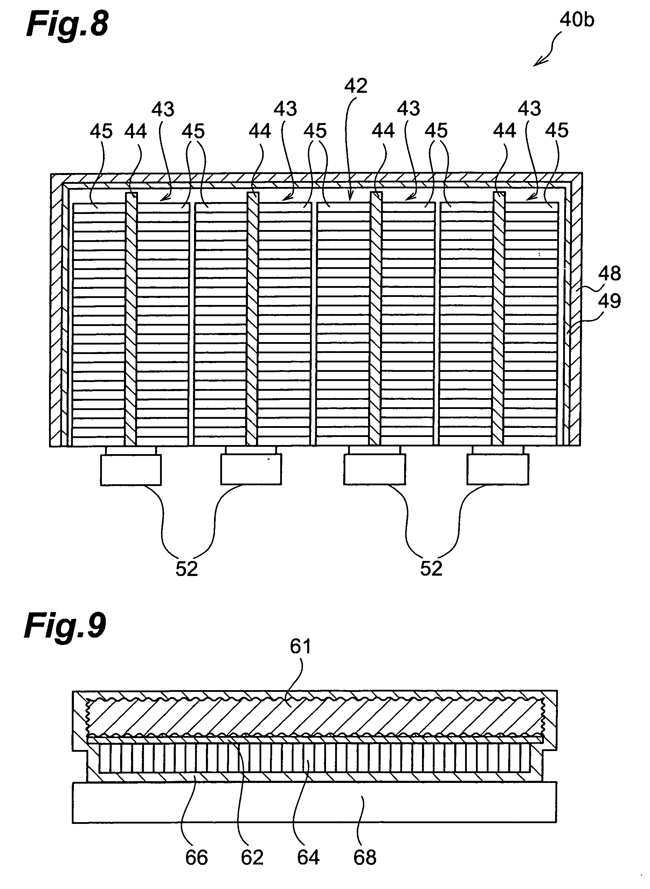

An energy discriminator that is a sixth embodiment of this invention shall now be described. FIG. 8 is a sectional side view of this energy discriminator. This energy discriminator 40b comprises the same stacked scintillator panel 42 as those of the above-described fourth and fifth embodiments and the case 48 that houses the stacks. Also the metal reflecting film 49 is formed on the interior of the case 48.

Meanwhile, at the sides of the open face of the case 48 of the respective substrates 44 in the scintillator panels 43 that form the stacked scintillator panel 42 of the present embodiment are mounted four photodetectors, that is, four solid-state linear sensors 52. These solid-state linear sensors 52 detect the light transmitted through the substrate 44.

With the energy discriminator 40b according to the present embodiment having the above arrangement, the incident energy along the direction of stacking the stacked scintillator panel 42. The incident radiation passes through the stacked scintillator panel 42 successively and eventually causes scintillation emission and emits visible light. The visible light is transmitted through the substrates 44 of the scintillator panel 43 that emits this visible light and arrives at the solid-state linear sensor 52. The radiation energy can be discriminated in accordance with the position of the solid-state linear sensor 52 at which the visible light arrives.

As with the image sensors described as the fourth and fifth embodiments, since the stacked scintillator panel 42 is used, the number of substrates required to provide an image sensor can be reduced with this embodiment's energy discriminator 40b as well.

Though preferred embodiments of this invention have been described above, this invention is not restricted to the respective embodiments described above.

For example, though with the first to third embodiments described above, reflecting films are formed on the surfaces of the scintillator, reflecting films or other light shielding films may also be formed on the back face sides of the substrates for crystal deposition and the retainer plate that face scintillator surfaces. Besides using vapor deposition, such light shielding films, etc., may be simply adhered onto the scintillator or substrates for crystal deposition. In regard to the relationship of the light shielding film and the reflecting film, the reflecting film itself may be the light shielding film or a reflecting film may provided apart from the light shielding film.

Also, though with the above-described embodiments, the reflecting films are formed only on the surfaces of the scintillator, the reflecting films may be formed so as to cover the entire scintillator. In particular, by forming a light shielding film (reflecting film) on the entire inner side of the protective film, the light shielding property (reflecting property) of each individual scintillator can be improved.

Furthermore, though a protective film is formed in the above-described embodiments, an aspect wherein this protective film is not formed is also possible. Furthermore, though the protective film and the metal reflecting film are formed so as to cover the scintillator, these may be formed, for example, between the substrates and the scintillator. The reflecting films do not have to be metallic and may be arranged from a resin, etc., that simply has a light shielding property.

Also, though in the fourth to sixth embodiments described above, transparent substrates are used, the substrates in these embodiments are not limited to those that are transparent, and substrates that are nontransparent, semitransparent, etc., may be used instead. Also, in the case where scintillator that emit ultraviolet light or infrared light upon radiation incidence are used, substrates having the characteristic of enabling favorable transmission of such light should be used. Here, besides embodiments wherein light is transmitted inside the substrates, embodiments wherein light is transmitted outside the substrates by reflection may be used in likewise manner.

Also, though with the embodiments described above, CsI(Tl) is used as the scintillator, this invention is not limited thereto, and for example, CsI(Na), NaI(Tl), LiI(Eu), Ki(Tl), etc., may be used instead. In the case where a plurality of scintillator panels are stacked, the individual scintillator and substrates do not have to be made of the same materials and different scintillator and substrate materials may be combined. In this case, that a substrate is light transmitting signifies that it has the property of transmitting at least a portion of the wavelength range that includes the wavelength of the light emitted by the corresponding scintillator.

### Industrial Applicability

This invention's scintillator panel and scintillator member can be used favorably in radiation image sensors, radiation detectors, energy discriminators, etc., and are favorable for X-ray and γ-ray detection and image taking for medical and industrial applications.

## Claims

1. A scintillator panel **characterized by** comprising of stacking a plurality of panels, each comprising of a substrate for crystal deposition, made of a light transmitting material that transmits at least a predetermined wavelength range light; and a scintillator, deposited onto the substrate by vapor deposition and emitting light, including wavelength range light transmitted through the substrate, upon radiation incidence.

2. The scintillator panel according to Claim 1, further comprising light shielding films disposed between the stacked panels.

3. The scintillator panel according to Claim 2, wherein the light shielding films include reflecting films.

4. The scintillator panel according to any of Claims 1 through 3, further comprising a retainer plate disposed so as to face a scintillator surface that does not face a substrate after stacking.

5. The scintillator panel according to any of Claims 1 through 4, further comprising a protective film coating over the entire stacks having a plurality of laminated panels.

6. A radiation image sensor comprising: the scintillator panel according to any of Claims 1 through 5; and photoelectric conversion elements connected to the substrates.

7. A radiation image sensor comprising: the scintillator panel according to any of Claims 1 through 5; and an image pickup element connected to the substrates.

8. A radiation energy discriminator comprising: the scintillator panel according to any of Claims 1 through 5; and photodetectors connected to the substrates.

9. A scintillator panel comprising: a substrate, having a front surface and a corresponding back surface, and scintillator, vapor-deposited respectively on the front surface and the back surface of the substrate.

10. The scintillator panel according to Claim 9, wherein the substrate is made of a light transmitting material that transmits the light emitted from the scintillator.

11. The scintillator panel according to Claim 10, wherein the light transmitting material is glass.

12. The scintillator panel according to Claim 9 or 10, wherein the substrate includes a metal material.

13. The scintillator panel according to Claim 9 or 10, wherein the substrate includes a carbon-based material.

14. The scintillator panel according to any of Claims 9 through 13, further comprising a protective film coating the surfaces of the scintillator.

15. The scintillator panel according to Claim 14, wherein the protective film has a hygroscopicity.

16. The scintillator panel according to any of Claims 9 through 15, further comprising a reflecting film formed on the surfaces of the scintillator.

17. A stacked scintillator panel, formed by stacking a plurality of the scintillator panels according to any of Claims 9 through 16.

18. A radiation image sensor comprising: the stacked scintillator panel according to Claim 17; and
photoelectric conversion elements connected to the stacked panel.

19. A radiation image sensor comprising: the stacked scintillator panel according to Claim 17; and
an image pickup element connected to the stacked panel.

20. A radiation energy discriminator comprising: the stacked scintillator panel according to Claim 17; and
photodetectors connected to the stacked panel.
